# EUROPEAN PATENT APPLICATION

(11) **EP 2 397 902 A1**
(43) Date of publication of application: **21.12.2011**
(21) Application number: 10741104.3
(22) Date of filing: 12.02.2010
(51) Int. Cl.: G03F 7/023, G03F 7/075

(54) **POSITIVE PHOTOSENSITIVE RESIN COMPOSITION, CURED FILM USING SAME, PROTECTIVE FILM, INSULATING FILM, SEMICONDUCTOR DEVICE, AND DISPLAY DEVICE**

(30) Priority: 13.02.2009 JP 2009031743
(71) Applicant: Sumitomo Bakelite Co., Ltd., Shinagawa-ku Tokyo 140-0002 (JP)
(72) Inventor: HASEGAWA, Masatoshi, Funabashi-shi Chiba 274-0072 (JP)
(74) Representative: Müller, Christian Stefan Gerd
(86) International application number: PCT/JP2010/000873
(87) International publication number: WO 2010/092824

(57) **Abstract**

Disclosed is a positive photosensitive resin composition which can reduce warping of a substrate such as a semiconductor wafer or the like even when the positive photosensitive resin composition is subjected to dehydration ring closing by the application of a thermal history; a cured film; a protecting film; an insulating film; a semiconductor device; and a display device. The positive photosensitive resin composition comprises a polyamide resin mainly composed of a polybenzoxazole precursor and being patterned on the substrate such as a semiconductor wafer or the like by coating, exposure and development. The cured film is obtained by subjecting the positive photosensitive resin composition containing a polyamide resin mainly composed of a polybenzoxazole precursor to dehydration ring closing. The protecting film comprises the cured film. Specifically disclosed is a positive photosensitive resin composition comprises a polyamide resin (A) and a photosensitizing agent (B), wherein the polyamide resin comprises a repeating unit (A-1) represented by the general formula (1), and a repeating unit (A-2) represented by the general formula (2) and/or a repeating unit (A-3) represented by the general formula (3).

## Description

### TECHNICAL FIELD

The present invention relates to a positive photosensitive resin composition, a cured film using the resin composition, a protecting film, an insulating film, a semiconductor device and a display device.

### BACKGROUND ART

In recent year, an importance of polyimide as a heat resistant insulating material in electronic equipments has ever been increased. At present, polyimide has been widely used for various uses such as flexible printed wiring circuit boards, base materials for tape-automated bonding, protecting films of semiconductor elements, interlayer insulating films of integrated circuits and the like because polyimide has characteristics such as chemical resistance, radiation resistance, electric insulation, excellent mechanical properties and the like, as well as excellent heat resistance.

Polyimide can be relatively easily produced by subjecting diamine and tetracarboxylic dianhydride to an equimolar polyaddition reaction in the presence of a solvent such as N-methyl-2-pyrrolidone or the like without a catalyst to polymerize a solvent-soluble precursor (polyamic acid), and subjecting this varnish to solution casting film formation/drying/thermal dehydration ring closure reaction (imidization reaction). In addition thereto, polyimide is suitable for use in semiconductors unfavorably affected by residual halogen, metal ion or the like which might cause a deterioration in electrical characteristics and should be avoided, from the viewpoint of extremely high film purity. Polyimide is also favorable from the viewpoints of easily improving physical properties by use of various available monomers and easily coping with required characteristics which have recently been diversified.

As a protective coating material of a surface of a semiconductor chip, heat resistant polyimide has been currently used for the purposes of protection of the chip from curing and shrinking of an encapsulation material such as an epoxy resin or the like, protection of the chip from thermal impact in a solder reflow process and sudden thermal expansion stress of an encapsulation material, prevention of cracking when an inorganic passivation film is formed on the chip, prevention of soft error due to shielding of α-rays emitted from a minute amount of uranium or thorium contained in an inorganic filler in the encapsulation material, interlayer insulation of multi-layer wiring circuits, prevention of disconnection of wiring due to flattening or the like.

In order to use polyimide as a buffer coating film, a passivation film or the like for the above-mentioned purposes, such polyimide requires not only heat resistance with respect to a thermal process during the production of a semiconductor, adhesiveness and extremely low ionic impurities, but also low moisture absorption properties and low thermal expansion properties for the protection of the chip from moisture, and further requires high elasticity for the protection of the chip from silica or the like contained in the encapsulation resin. Thus, as a polyimide film has higher elasticity as a chip protecting film, a thinner film can be designed.

A protective coating material is subjected to microprocessing such as formation of via holes on a bonding pad section by plasma etching or alkali etching. A high resolution is generally achieved by a dry method such as plasma etching or the like which incurs the cost in respect of the equipment, whereas wet etching using alkali or the like is much simpler.

According to microprocessing of the conventional polyimide film, a photoresist layer is formed on a polyimide film and a portion exposed by development is etched with hydrazine or alkali. However, by use of a photosensitive polyimide provided with photosensitive performance to polyimide or its precursor itself, microprocessing of polyimide is greatly shortened, so that improvement in the semiconductor production rate and the yield rate is expected.

For this purpose, an alkali-developable positive photosensitive polyimide obtained by dispersing a diazonaphthoquinone type photosensitizing agent in a polyamic acid film, i.e., a polyimide precursor has been reviewed. However, since the pKa value of a carboxyl group in the polyamic acid is as low as 4 to 5, the solubility of the polyamic acid to an aqueous solution of 2.38 % by weight tetramethylammonium hydroxide which is usually used for the production process of a semiconductor is too high, which is not suitable for microprocessing.

In later years, requirements for much higher resolution in microprocessing have been increased year by year. However, there has been used a positive photosensitive resin in combination with a diazonaphthoquinone type photosensitizing agent and a polybenzoxazole precursor (polyhydroxyamide) exhibiting suitable alkaline solubility because of a phenolic hydroxy group having much higher pKa value of about 10, instead of a photosensitive polyimide precursor which is not suitable for the aforementioned alkaline development (for example, refer to Patent Document 1).

A polybenzoxazole film obtained by subjecting polyhydroxyamide, i.e., a polybenzoxazole precursor, to a thermal ring closure reaction, is excellent as a semiconductor protective coating material, because the polybenzoxazole film is not only excellent in microprocessing performance as described above, but also excellent in heat resistance equivalent to polyimide and much excellent in low water absorption properties as compared to polyimide.

However, in recent years, with the progress of an increase in size of a semiconductor wafer, when a polybenzoxazole precursor is subjected to dehydration ring closing by the application of a thermal history after patterning a positive photosensitive resin composition mainly composed of a current polybenzoxazole precursor by exposure and development, a semiconductor wafer is warped. Thus, defects are caused during wiring processing or dicing process thereafter in some cases.

A material that is very favorable in the above industry field can be provided as long as there is a positive photosensitive resin composition with small warpage of a semiconductor wafer when the polybenzoxazole precursor contained in the positive photosensitive resin composition is subjected to dehydration ring closing by the application of a thermal history. However, in reality, such a material satisfying the above required characteristics has not yet known.

Patent Document 1: Japanese Patent Laid-Open No. 1999-242338

### DISCLOSURE OF THE INVENTION

An object of the present invention is to provide a positive photosensitive resin composition which can reduce warping of a substrate such as a semiconductor wafer or the like even when the positive photosensitive resin composition is subjected to dehydration ring closing by the application of a thermal history; a cured film; a protecting film; an insulating film; a semiconductor device; and a display device. The positive photosensitive resin composition contains a polyamide resin mainly composed of a polybenzoxazole precursor and being patterned on the substrate such as a semiconductor wafer or the like by coating, exposure and development. The cured film is obtained by subjecting the positive photosensitive resin composition containing a polyamide resin mainly composed of a polybenzoxazole precursor resin to dehydration ring closing. The protecting film comprises the cured film.

Such an object is achieved by the present invention as specified by the matters described in the following [1] to [12].
[1] A positive photosensitive resin composition comprising a polyamide resin (A) and a photosensitizing agent (B), wherein the polyamide resin comprises a repeating unit (A-1) represented by the following general formula (1), a repeating unit (A-2) represented by the following general formula (2) and/or a repeating unit (A-3) represented by the following general formula (3), 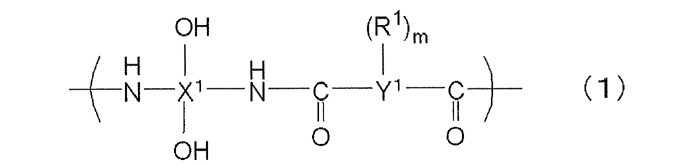 wherein, in the formula, each of X¹ and Y¹ is an organic group; R¹ is any one of a hydrogen atom, a hydroxyl group and -O-R²; m is an integer of 0 to 8; when there are a plurality of R¹,R¹ may be the same or different from each other; and R² is an organic group having 1 to 15 carbon atoms, 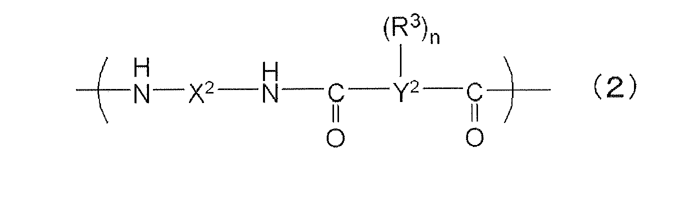 wherein, in the formula, X² is a structural unit represented by the following general formula (40); Y² is an organic group; R³ is any one of a hydrogen atom, a hydroxyl group and -O-R⁴; n is an integer of 0 to 8; when there are a plurality of R³, R³ may be the same or different from each other; and R⁴ is an organic group having 1 to 15 carbon atoms, 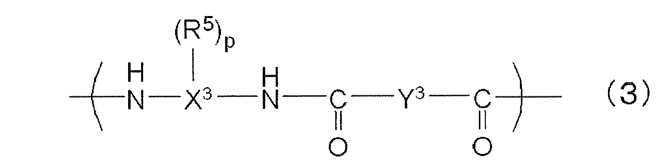 wherein, in the formula, X³ is an organic group; Y³ is a structural unit represented by the following general formula (40); R⁵ is any one of a hydrogen atom, a hydroxyl group and -O-R⁶; p is an integer of 0 to 8; when there are a plurality of R⁵, R⁵ may be the same or different from each other; and R⁶ is an organic group having 1 to 15 carbon atoms, 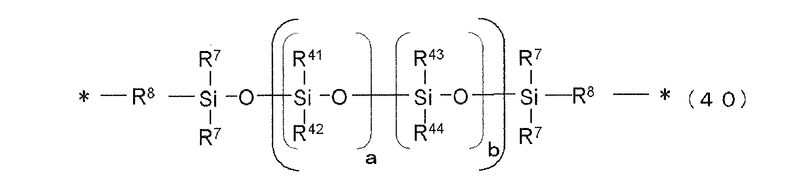 wherein, in the formula, R⁷ is a hydrogen atom or a hydrocarbon group having 1 to 10 carbon atoms; R⁸ is a hydrocarbon group having 1 to 10 carbon atoms; at least one of R⁴¹, R⁴², R⁴³ and R⁴⁴ is an aryl group, and other groups of the R⁴¹, R⁴², R⁴³ and R⁴⁴ are each a hydrogen atom or an organic group having 1 to 30 carbon atoms, which may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2) and/or a C=O group represented by the general formula (3).
[2] The positive photosensitive resin composition according to [1], wherein the structural unit represented by the aforementioned general formula (40) is represented by the following general formula (4), 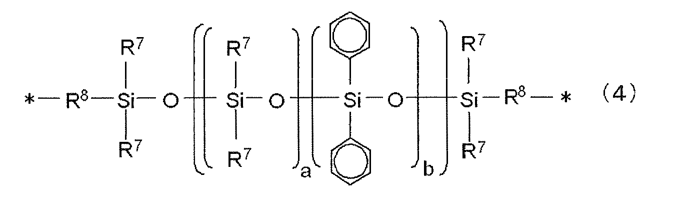 wherein, in the formula, R⁷ is a hydrogen atom or a hydrocarbon group having 1 to 10 carbon atoms; R⁸ is a hydrocarbon group having 1 to 10 carbon atoms; R⁷ and R⁸ may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2) and/or a C=O group represented by the general formula (3).
[3] The positive photosensitive resin composition according to [1] or [2], wherein the molecular weight of the structural unit represented by the general formula (40) is from 400 to 4,000.
[4] The positive photosensitive resin composition according to [2] or [3], wherein said polyamide resin comprises a repeating unit (A-2) represented by the general formula (2), 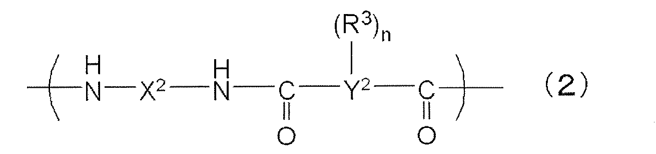 wherein, in the formula, X² is a structural unit represented by the following general formula (4); Y² is an organic group; R³ is any one of a hydrogen atom, a hydroxyl group and -O-R⁴; n is an integer of 0 to 8; when there are a plurality of R³,R³ may be the same or different from each other; and R⁴ is an organic group having 1 to 15 carbon atoms, 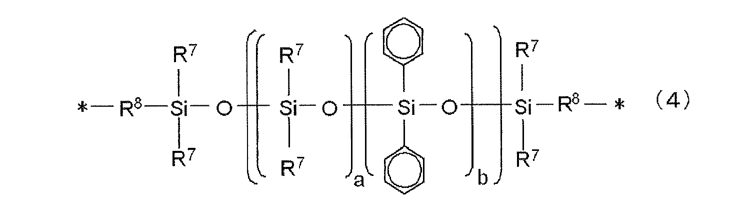 wherein, in the formula, R⁷ is a hydrogen atom or a hydrocarbon group having 1 to 10 carbon atoms; R⁸ is a hydrocarbon group having 1 to 10 carbon atoms; R⁷ and R⁸ may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2).
[5] The positive photosensitive resin composition as set forth in any one of [1] to [4], wherein the molar ratio ((A-1)/{(A-2)+(A-3)}) of the repeating unit (A-1) represented by the aforementioned general formula (1) to the repeating unit (A-2) represented by the aforementioned general formula (2) and/or the repeating unit (A-3) represented by the aforementioned general formula (3) is from 0.05 to 0.95.
[6] The positive photosensitive resin composition as set forth in any one of [1] to [4], wherein X¹ in the structural unit represented by the aforementioned general formula (1) contains at least one kind selected from the groups of the following formula (5), 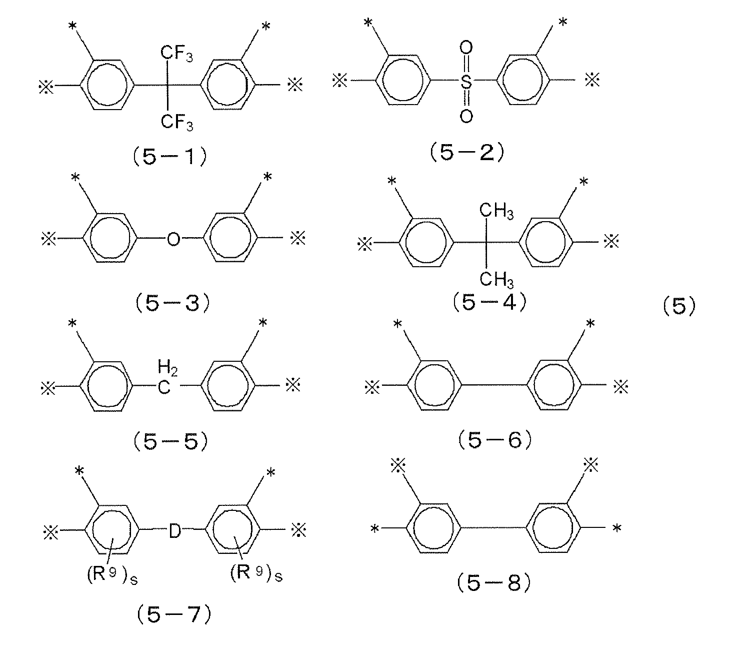 wherein, the asterisk (*) represents bonding to an NH 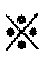 group; represents bonding to a hydroxyl group; D in the formula is -CH₂-, -CH(CH₃)-, -C(CH₃)₃-, -O-, -S-, -SO₂-, -CO-, -NHCO-, -C(CF₃)₂- or a single bond; s is an integer of 1 to 3; R⁹ represents one selected from an alkyl group, an alkoxy group, an acyloxy group and a cycloalkyl group; and when there are a plurality of R⁹, R⁹ may be the same or different from each other.
[7] The positive photosensitive resin composition as set forth in any one of [1] to [4], wherein Y¹ in the structural unit represented by the aforementioned general formula (1) contains at least one kind selected from the groups of the following formula (6), 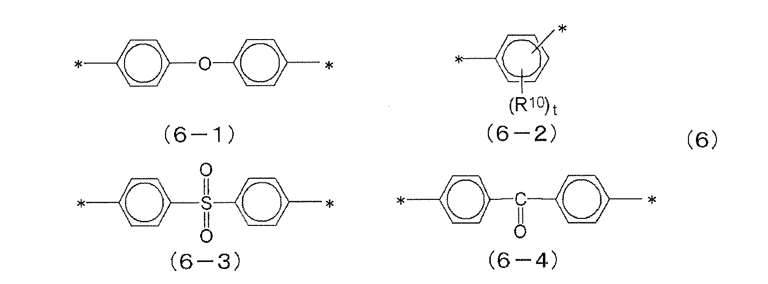 wherein, the asterisk (*) represents bonding to a C=O group; t is an integer of 0 to 2; R¹⁰ represents one selected from an alkyl group, an alkyl ester group, an alkyl ether group and a halogen atom; and when there are a plurality of R¹⁰, R¹⁰ may be the same or different from each other.
[8] A cured film comprising a cured product of the positive photosensitive resin composition as set forth in any one of [1] to [7], wherein the elastic modulus at 25 °C is not more than 1.5 GPa.
[9] A protecting film comprising the cured film as set forth in [8].
[10] An insulating film comprising the cured film as set forth in [8].
[11] A semiconductor device comprising the cured film as set forth in [8].
[12] A display device comprising the cured film as set forth in [8].

According to the present invention, there are obtained a positive photosensitive resin composition which can reduce warping of a substrate such as a semiconductor wafer or the like even when the positive photosensitive resin composition is subjected to dehydration ring closing by the application of a thermal history; a cured film thereof; a protecting film having the cured film; an insulating film; a semiconductor device; and a display device. The positive photosensitive resin composition comprises a polyamide resin mainly composed of a polybenzoxazole precursor and being patterned on the substrate such as a semiconductor wafer or the like by coating, exposure and development.

### BRIEF DESCRIPTION OF THE DRAWINGS

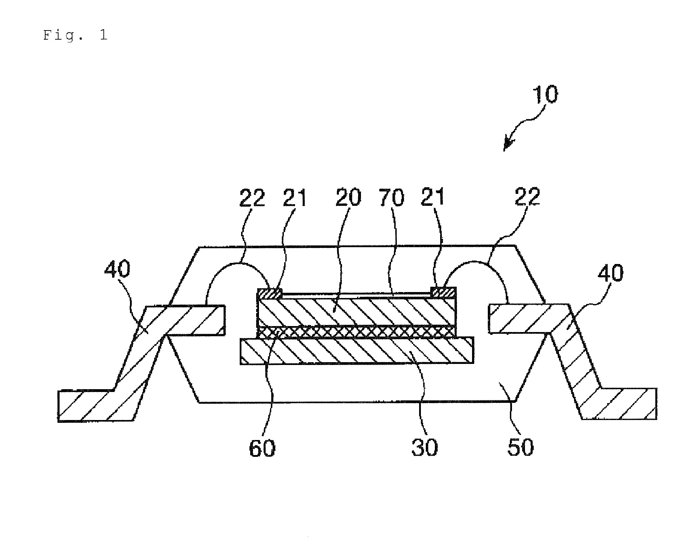

Fig. 1 is a longitudinal sectional view showing an example of a semiconductor device of the present invention.

### BEST MODE FOR CARRYING OUT THE INVENTION

Hereinafter, the positive photosensitive resin composition of the present invention, the cured film using the positive photosensitive resin composition, the protecting film, the insulating film, the semiconductor device and the display device of the present invention will be described each in detail on the basis of a suitable embodiment illustrated in the accompanying drawing.

First, a semiconductor device having the positive photosensitive resin composition as a protecting film (a chip coating film) will be described, prior to description of the positive photosensitive resin composition of the present invention.

Fig. 1 is a longitudinal sectional view showing an example of a semiconductor device. Incidentally, in the description, the upper part in Fig. 1 is referred to as the top while the lower part is referred to as the bottom.

A semiconductor device 10 shown in Fig. 1 is a QFP (Quad Flat Package) type semiconductor package, and comprises a semiconductor chip (a semiconductor element) 20, a die pad 30 for supporting the semiconductor chip 20 via an adhesive layer 60, a protecting film 70 for protecting the semiconductor chip 20, leads 40 for electrically connecting to the semiconductor chip 20, and a mold section 50 for encapsulating the semiconductor chip 20.

The die pad 30 is composed of a metal substrate, and has a function as a support for supporting the semiconductor chip 20.

As the die pad 30, there are used, for example, a metal substrate composed of various metal materials such as copper (Cu), iron (Fe), nickel (Ni), an alloy of these elements (for example, a Cu alloy or an iron-nickel alloy such as Fe-42Ni) or the like, a metal substrate with its surface subjected to silver plating or nickel-lead (Ni-Pd) plating, a metal substrate having a gold plated (gold flash) layer formed for enhancing the stability of a Pd layer on the Ni-Pd plated surface, and the like.

Additionally, the plan view of the die pad 30 usually corresponds to the plan view of the semiconductor chip 20, and is, for example, a square or a quadrangle such as a rectangle.

A plurality of leads 40 are radially arranged in the periphery portion of the die pad 30.
The end portions of the leads 40 opposite to the die pad 30 are projected (exposed) from the mold section 50.

Additionally, a surface of the exposed portion of the lead 40 from the mold section 50 may be subjected to a surface treatment such as gold plating, tin plating, solder plating, solder coating or the like. Accordingly, when the semiconductor device 10 is connected to a terminal having a motherboard through a solder, adhesiveness between the solder and the lead 40 can be enhanced.

Furthermore, not only the exposed portion from the mold section 50, but also the entire lead 40 may be subjected to such a surface treatment of the lead 40.

The lead 40 is composed of a conductive material, and may be, for example, the same as the constituent material of the aforementioned die pad 30.

The semiconductor chip 20 is attached (fixed) to the die pad 30 through the adhesive layer 60 composed of a cured product of the resin composition (a liquid resin composition).

The adhesive layer 60 has a function of connecting the die pad 30 and the semiconductor chip 20, and has a function of transferring (radiating) the heat generated during driving of the semiconductor chip 20 to the die pad 30 side.

As the adhesive layer 60, suitably used is a material composed of a thermosetting resin such as an epoxy resin, an acrylic compound or a polyimide resin, which contains, for example, metal powder such as silver powder, aluminum powder or nickel powder; or ceramic powder such as silica powder, alumina powder or titanium powder as a filler.

Electrode pads 21 are arranged on the upper surface of the semiconductor chip 20, and the electrode pads 21 and the leads 40 are electrically connected by means of wires 22. Accordingly, the semiconductor chip 20 and respective leads 40 are electrically connected.

A material of the wires 22 is not particularly limited, but the wires 22 may be composed, for example, of a gold (Au) wire or an aluminum (Al) wire.

Additionaly, the protecting film (chip coating film) 70 is formed on the semiconductor chip 20 such that the electrode pads 21 are exposed.

The protecting film 70 has a function of protecting the semiconductor chip 20 when it is formed by curing and shrinking the mold section 50, and has a function of protecting the semiconductor chip 20 from thermal impact in a solder reflow process for mounting the semiconductor chip 20 on the substrate and sudden thermal expansion stress of a mold material.

The present invention has characteristics in the construction of the protecting film 70 such that the protecting film 70 is mainly composed of the positive photosensitive resin composition of the present invention. The positive photosensitive resin composition will be described later.

Furthermore, the die pad 30, respective members arranged on the upper surface of the die pad 30 and the inner portion of the leads 40 are encapsulated by the mold section 50. As a result, the outer end portions of the leads 40 are projected from the mold section 50.

This mold section 50 may be composed, for example, of various resin materials such as an epoxy resin and the like.

The semiconductor device 10 can be produced, for example, in the following manner.
First, a lead frame comprising the die pad (support) 30 and a plurality of leads (terminals) 40 is prepared.

Separately, the semiconductor chip 20 with the protecting film 70 patterned so as to expose the electrode pads 21 is prepared.

Formation of the protecting film 70 on the semiconductor chip 20 may be carried out, for example, in the following manner. First, a liquid material (a varnish) containing a polyamide resin and a photosensitizing agent is supplied so as to cover almost all over the entire upper surface of the semiconductor chip 20. Subsequently, this liquid material is dried, whereby a film containing a polyamide resin and a photosensitizing agent is formed on the upper surface of the semiconductor chip 20. Then, the film formed at a position corresponding to the electrode pads 21 is exposed to light, followed by etching. Accordingly, the aforementioned film is patterned in a shape such that the electrode pads 21 are exposed. Thereafter, a polybenzoxazole precursor copolymer contained in the aforementioned patterned film is subjected to a ring closure reaction to give a polybenzoxazole copolymer, whereby the protecting film 70 can be obtained.

An average film thickness of the protecting film 70 is preferably from about 1 to 20 µm and more preferably from about 5 to 10 µm. Accordingly, the aforementioned functions are surely exhibited as a protecting film.

Next, for example, the constituent material of the adhesive layer 60 before curing is supplied on the die pad 30 using a discharge device such as a commercial die bonder or the like.

Then, the semiconductor chip 20 is mounted on the die pad 30 and heated, such that a surface having the protecting film 70 arranged thereon is the upper side and the constituent material of the adhesive layer 60 before curing is interposed between the semiconductor chip 20 and the die pad 30. Accordingly, the constituent material of the adhesive layer 60 before curing is cured, so that the adhesive layer 60 composed of a cured product is formed. As a result, the semiconductor chip 20 is bonded on the die pad (support) 30 through the adhesive layer 60.

Next, the conductive wires 22 are formed between the electrode pads 21 exposed from the protecting film 70 and the leads 40 by means of wire bonding. Accordingly, the electrode pads 21 and the leads 40 are electrically connected.

Then, for example, the mold section 50 is formed by means of transfer molding or the like.
Thereafter, the semiconductor device 10 is manufactured by punching a tie bar encapsulated with a resin from a lead frame and carrying out a trim and form process.

In the semiconductor device 10 of the present invention, it is required that the protecting film 70 has much lower water absorption rate for the purpose of exhibiting the aforementioned functions as the protecting film 70, and has more excellent light transmissibility so as to pattern in a finer shape. For the purpose of obtaining a protecting film excellent in such characteristics, in recent years, a film composed of a polyamide resin mainly composed of a polybenzoxazole precursor has been studied in various ways as the protecting film (chip coating film) 70.

The present inventors have paid attention to a film comprising a polyamide resin mainly composed of such a polybenzoxazole precursor, and have conducted an extensive study and as a result, have found that there is a problem of an increase in warping of a substrate such as a semiconductor wafer or the like, when a polyamide resin mainly composed of a polybenzoxazole precursor is subjected to dehydration ring closing by selecting a polyamide resin having a rigid skeleton and high linearity as the polyamide resin mainly composed of a polybenzoxazole precursor, in order to achieve low water absorption rate and high light transmissibility of a film to be formed.

However, they have found that the above problem can be solved by providing a polyamide resin obtained by subjecting a polyamide resin comprising a repeating unit (A-1) represented by the following general formula (1), a repeating unit (A-2) represented by the following general formula (2) and/or a repeating unit (A-3) represented by the following general formula (3) to a ring closure reaction as a main material of the protecting film. Thus, the present invention has been completed.

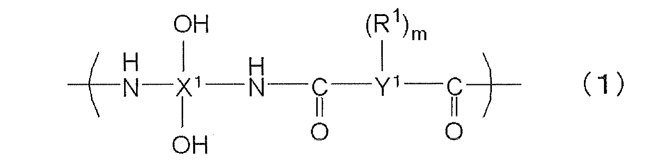

wherein, in the formula, each of X¹ and Y¹ is an organic group; R¹ is any one of a hydrogen atom, a hydroxyl group and -O-R²; m is an integer of 0 to 8; when there are a plurality of R¹, R¹ may be the same or different from each other; and R² is an organic group having 1 to 15 carbon atoms,

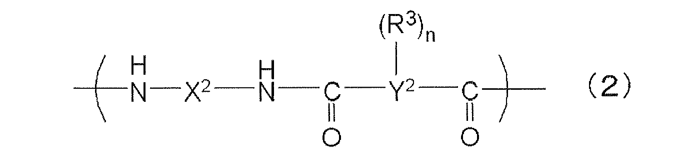

wherein, in the formula, X² is a structural unit represented by the following general formula (40); Y² is an organic group; R³ is any one of a hydrogen atom, a hydroxyl group and -O-R⁴; n is an integer of 0 to 8; when there are a plurality of R³, R³ may be the same or different from each other; and R⁴ is an organic group having 1 to 15 carbon atoms,

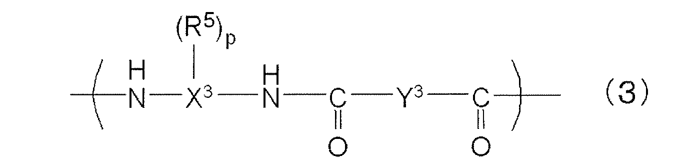

wherein, in the formula, X³ is an organic group; Y³ is a structural unit represented by the following general formula (40); R⁵ is any one of a hydrogen atom, a hydroxyl group and -O-R⁶; p is an integer of 0 to 8; when there are a plurality of R⁵, R⁵ may be the same or different from each other; and R⁶ is an organic group having 1 to 15 carbon atoms,

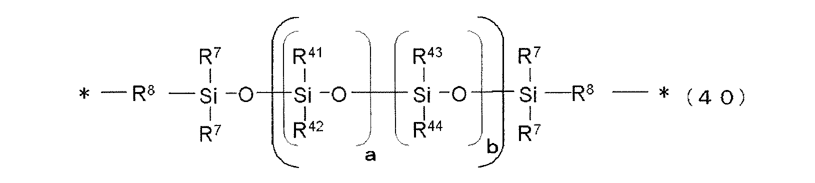

wherein, in the formula, R⁷ is a hydrogen atom or a hydrocarbon group having 1 to 10 carbon atoms; R⁸ is a hydrocarbon group having 1 to 10 carbon atoms; at least one of R⁴¹, R⁴², R⁴³ and R⁴⁴ is an aryl group, and other groups of the R⁴¹, R⁴², R⁴³ and R⁴⁴ are each a hydrogen atom or an organic group having 1 to 30 carbon atoms, which may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2) and/or a C=0 group represented by the general formula (3).

The positive photosensitive resin composition of the present invention has a characteristic in that a skeleton represented by the following general formula (40) is provided as a component used for obtaining a repeating unit represented by the general formula (2) and/or the general formula (3). Accordingly, the elastic modulus of a cured product of the polyamide resin can be lowered.

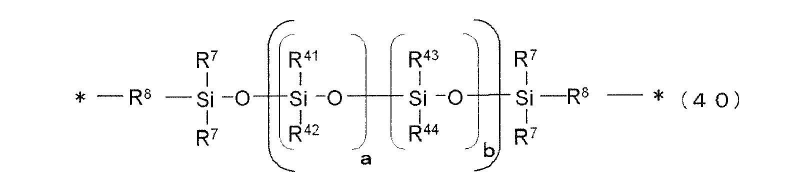

wherein, in the formula, R⁷ is a hydrogen atom or a hydrocarbon group having 1 to 10 carbon atoms; R⁸ is a hydrocarbon group having 1 to 10 carbon atoms; at least one of R⁴¹, R⁴², R⁴³ and R⁴⁴ is an aryl group, and other groups of the R⁴¹, R⁴², R⁴³ and R⁴⁴ are each a hydrogen atom or an organic group having 1 to 30 carbon atoms, which may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2) and/or a C=O group represented by the general formula (3).

In the above general formula (40), at least one of R⁴¹, R⁴², R⁴³ and R⁴⁴ may be an aryl group, and other groups of the R⁴¹, R⁴², R⁴³ and R⁴⁴ are each a hydrogen atom or an organic group having 1 to 30 carbon atoms, which may respectively be the same or different from each other. As the aryl group, preferably used are a phenyl group, a phenyl group having a substituent and a naphthyl group, and particularly preferably used is a phenyl group. As the organic group having 1 to 30 carbon atoms, preferably used are a methyl group, an ethyl group, an i-propyl group, an n-propyl group, an n-butyl group, a polyether group, an aralkyl group, a fluoroalkyl group, an ester group and an amide group, while particularly preferably used are a methyl group and an ethyl group. Incidentally, the structural unit represented by the following general formula (40) may contain -[Si(R⁴¹) (R⁴²)O]- and -[Si(R⁴³) (R⁴⁴)O]-, or may be a block structure or a random structure.

Additionally, in the positive photosensitive resin composition of the present invention, diamine comprising a siloxane skeleton represented by the following general formula (4) and an aromatic ring may be used as the structural unit represented by the general formula (40),

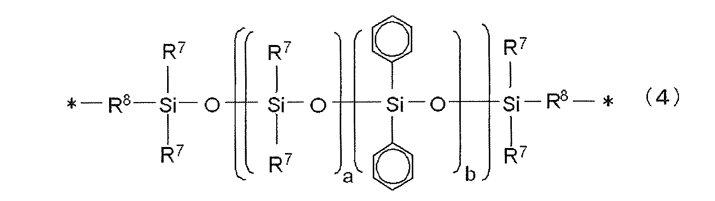

wherein, in the formula, R⁷ is a hydrogen atom or a hydrocarbon group having 1 to 10 carbon atoms; R⁸ is a hydrocarbon group having 1 to 10 carbon atoms; R⁷ and R⁸ may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2) and/or a C=O group represented by the general formula (3).

Incidentally, the structural unit represented by the general formula (4) may contain -[Si(R⁷)₂O]- and -[Si(Ph)₂O]-, or may be a block structure or a random structure.

By use of such diamine, the elastic modulus of a cured film of the polyamide resin according to the present invention can be lowered, and the stress on the semiconductor device having the cured film can be reduced.

The polyamide resin (A) in the positive photosensitive resin composition of the present invention comprises a repeating unit (A-1) represented by the above general formula (1), a repeating unit (A-2) represented by the general formula (2) and/or a repeating unit (A-3) represented by the general formula (3).

X¹ of the repeating unit (A-1) represented by the general formula (1) in the positive photosensitive resin composition of the present invention is not particularly limited, and examples include aromatic compounds such as a benzene ring, a naphthalene ring and the like; and heterocyclic compounds such as bisphenols, pyrroles, furans and the like. More specifically, a compound represented by the following formula (7) is preferable. These compounds may be used either individually or in combination of two or more kinds, as necessary.

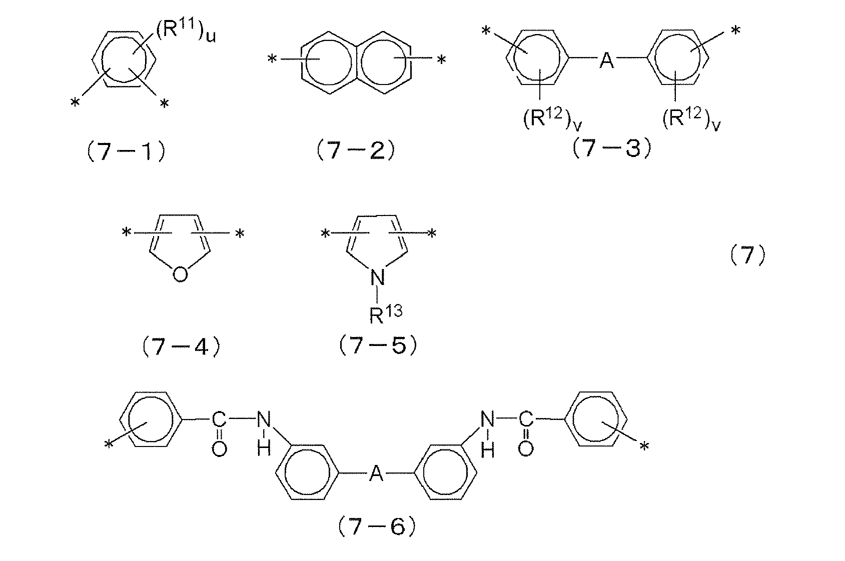

wherein, the asterisk (*) represents bonding to an NH group; A is -CH₂-, -C(CH₃)₂-, -CH(CH₃)-, -O-, -S-, -SO₂-, -CO-, -NHCO-, -COO-, -C(CF₃)₂- or a single bond; R¹¹ represents one selected from an alkyl group, an alkyl ester group and a halogen atom, and R¹¹ may be the same or different from each other; R¹² is any one of an alkyl group, an alkoxy group, an acyloxy group and a cycloalkyl group; when there are a plurality of R¹³, R¹³ may be the same or different from each other; R¹³ represents one selected from a hydrogen atom, an alkyl group, an alkyl ester group and a halogen atom; u is an integer of 0 to 2; and v is an integer of 0 to 3.

Particularly preferable examples among those represented by the formula (7) include those represented by the following formula (5). By use of these compounds, the heat resistance and moisture resistance of the cured film formed from the positive photosensitive resin composition can be enhanced.

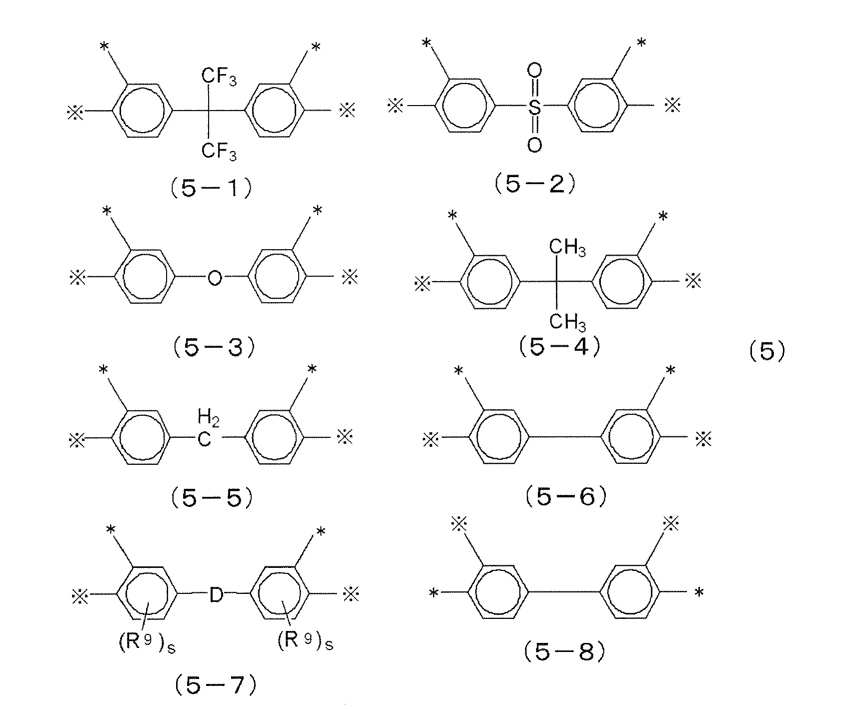

wherein, the asterisk (*) represents bonding to an NH group; 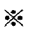 represents bonding to a hydroxyl group; D in the formula is -CH₂-, -CH(CH₃)-, -C(CH₃)₃-, -O-, -S-, -SO₂-, -CO-, -NHCO-, -C(CF₃)₂- or a single bond; s is an integer of 1 to 3; R⁹ represents one selected from an alkyl group, an alkoxy group, an acyloxy group and a cycloalkyl group; and when there are a plurality of R⁹, may be the same or different from each other.

Furthermore, Y¹ of the repeating unit (A-1) represented by the general formula (1) in the positive photosensitive resin composition of the present invention is an organic group, and examples include the same as those exemplified in the X¹, for example, aromatic compounds such as a benzene ring, a naphthalene ring and the like; heterocyclic compounds such as bisphenols, pyrroles, pyridines, furans and the like; siloxane compounds and the like. More specifically, a compound represented by the following formula (8) is preferable. These compounds may be used either individually or in combination of two or more kinds, as necessary.

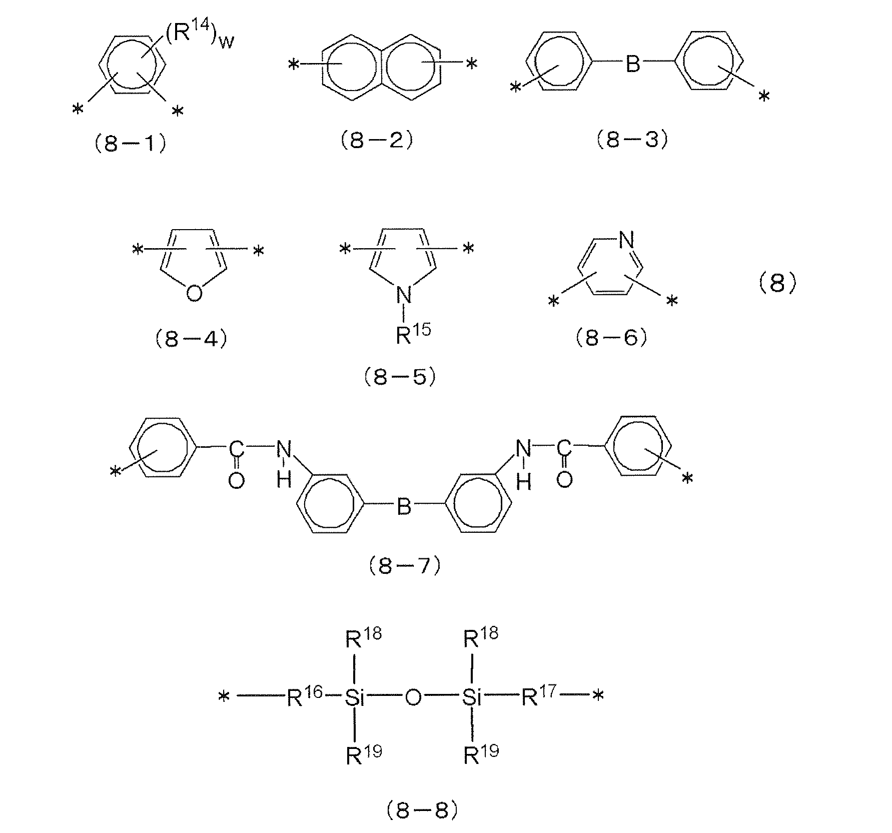

wherein, the asterisk (*)represents bonding to a C=O group; B in the formula is -CH₂-, -C(CH₃)₃-, -O-, -S-, -SO₂-, -CO-, -NHCO-, -C(CF₃)₂- or a single bond; R¹⁴ represents one selected from an alkyl group, an alkyl ester group and a halogen atom; when there are a plurality of R¹⁴, R¹⁴ may be the same or different from each other; R¹⁵ represents one selected from a hydrogen atom, an alkyl group, an alkyl ester group and a halogen atom; w is an integer of 0 to 4; and each of R¹⁶ to R¹⁹ is an organic group.

As shown in the general formula (1), 0 to 8 of R¹ are bonded to Y¹ (in the formula (8), R² is omitted).

Particularly preferable examples among those represented by the formula (8) include those represented by the following formula (6). By use of these compounds, the heat resistance and moisture resistance of the cured film formed from the positive photosensitive resin composition can be enhanced.

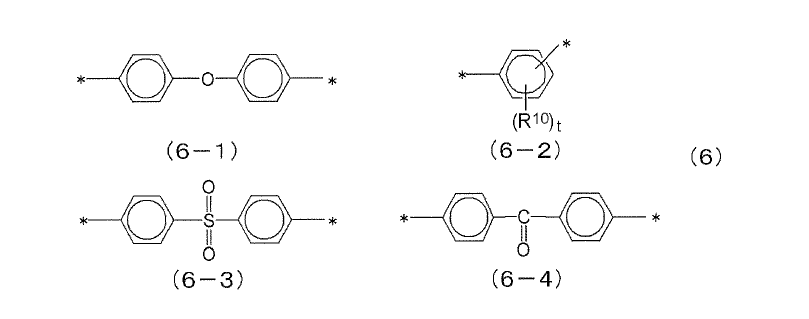

wherein, the asterisk (*)represents bonding to a C=O group; t is an integer of O to 2; R¹⁰ represents one selected from an alkyl group, an alkyl ester group, an alkyl ether group and a halogen atom; and when there are a plurality of R¹⁰, R¹⁰ may be the same or different from each other.

Y¹ of the repeating unit (A-2) represented by the general formula (2) in the positive photosensitive resin composition of the present invention is not particularly limited, and examples include the same as those exemplified in Y¹ of the general formula (1). As shown in the general formula (2), 0 to 8 of R³ are bonded to Y².

Additionally, X³ of the repeating unit (A-3) represented by the following general formula (3) in the positive photosensitive resin composition of the present invention is not particularly limited, and examples include the same as those exemplified in X¹ of the general formula (1). As shown in the general formula (3), 0 to 8 of R⁵ are bonded to X³.

In the positive photosensitive resin composition of the present invention, X² of the repeating unit (A-2) represented by the general formula (2) and/or Y³ of the repeating unit (A-3) represented by the general formula (3) have a structural unit represented by the following general formula (4),

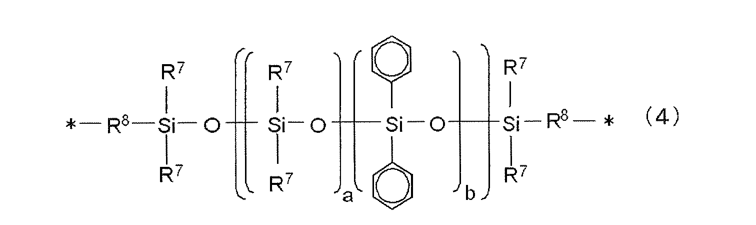

wherein, in the formula, R⁷ is a hydrogen atom or a hydrocarbon group having 1 to 10 carbon atoms; R⁸ is a hydrocarbon group having 1 to 10 carbon atoms; R⁷ and R⁸ may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2) and/or a C=O group represented by the general formula (3).

The polyamide resin (A) in the positive photosensitive resin composition of the present invention has, as mentioned above, a plurality of siloxane bonds, so that the elastic modulus of the cured film formed from the polyamide resin after dehydration ring closing is lowered, and the stress on the semiconductor device having the cured film is reduced. Furthermore, deterioration of the solubility to the constituent components of the positive photosensitive resin composition is suppressed by introducing a diphenylsiloxane structure, which is caused by an increase of the siloxane bonds alone.

R⁷ in the above general formula (4) is a hydrogen atom or a hydrocarbon group having 1 to 10 carbon atoms, is preferably a methyl group, an ethyl group, an i-propyl group, an n-propyl group or an n-butyl group, and particularly preferably a methyl group or an ethyl group. By having the above functional group as said R⁷, both of an effect of lowering the elastic modulus after subjecting the polyamide resin to dehydration ring closing and an effect of enhancing the solubility to the constituent components of the positive photosensitive resin composition can be achieved.

R⁸ in the above general formula (4) is a hydrocarbon group having 1 to 10 carbon atoms, is preferably a methylene group, an ethylene group, an n-propylene group or an n-butylene group, and particularly preferably a methylene group or an ethylene group. By having the above functional group as said R⁸, both of an effect of lowering the elastic modulus after subjecting the polyamide resin to dehydration ring closing and an effect of enhancing the solubility to the constituent components of the positive photosensitive resin composition can be achieved.

Each of a and b of the above general formula (4) represents mol %, a is from 5 to 95 mol %, b is from 95 to 5 mol %, and a+b is 100 mol %. a is preferably from 10 to 90 mol %, while b is preferably from 90 to 10 mol %. When a and b are in the above ranges, both of an effect of lowering the elastic modulus after subjecting the polyamide resin to dehydration ring closing and an effect of enhancing the solubility to the constituent components of the positive photosensitive resin composition can be achieved.

The molecular weight of the structural unit represented by the above general formula (4) is preferably from 400 to 4,000 and particularly preferably from 500 to 3,000. When the molecular weight is within the above range, both of an effect of lowering the elastic modulus after subjecting the polyamide resin to dehydration ring closing and an effect of enhancing the solubility to the constituent components of the positive photosensitive resin composition can be achieved.

Furthermore, the molar ratio ((A-1)/{(A-2)+(A-3)}) of the repeating unit (A-1) represented by the general formula (1) to the repeating unit (A-2) represented by the general formula (2) and/or the repeating unit (A-3) represented by the following general formula (3) is preferably from 0.05 to 0.95. Accordingly, the elastic modulus and the solubility are well balanced.

Additionally, the polyamide resin (A) comprising a repeating unit (A-1) represented by the aforementioned general formula (1), a repeating unit (A-2) represented by the general formula (2) and/or a repeating unit (A-3) represented by the general formula (3) has an amino group at one end thereof and the amino group may be preferably capped as an amide using an acid anhydride which contains an aliphatic group or a cyclic compound group having at least one carbon-carbon double bond unit or one carbon-carbon triple bond unit. Because of this, the storage stability of the positive photosensitive resin composition can be improved.

Examples of the group which is attributed to, as just described, the acid anhydride that is reacted with the amino group, the acid anhydride containing an aliphatic group or a cyclic compound group having at least one carbon-carbon double bond or one carbon-carbon triple bond include the groups represented by the following formulae (9) and (10). These compounds may be used either individually or in combination of two or more kinds.

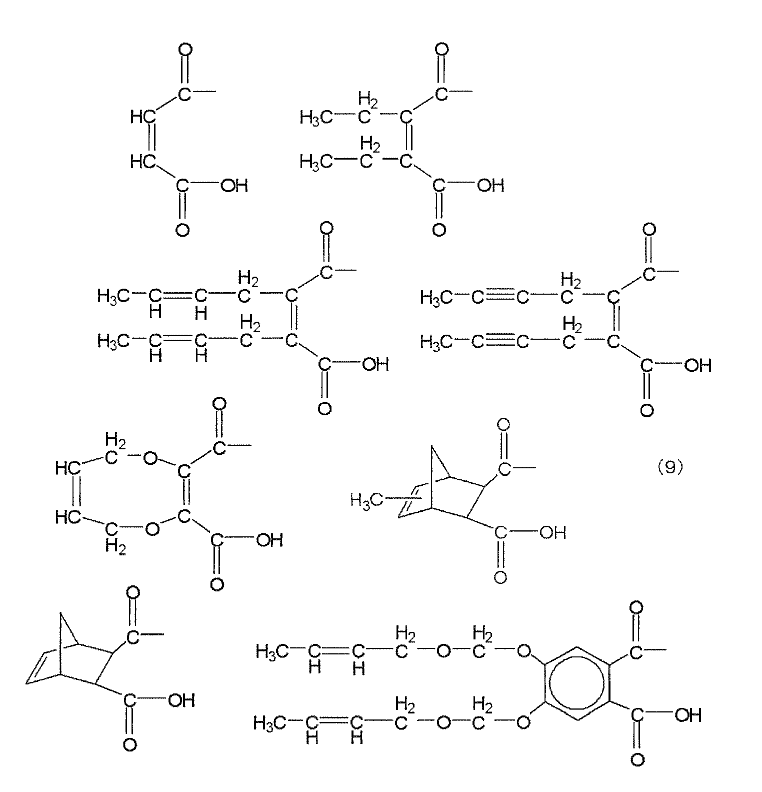

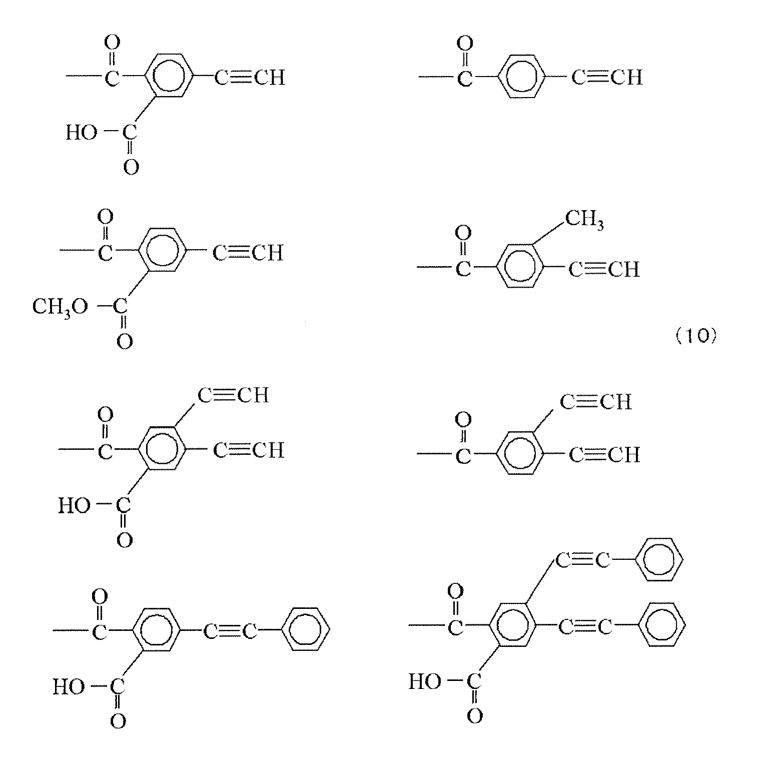

Among these groups, particularly preferable examples include the groups selected from the following formula (11). Accordingly, the storage stability of the positive photosensitive resin composition can be particularly improved.

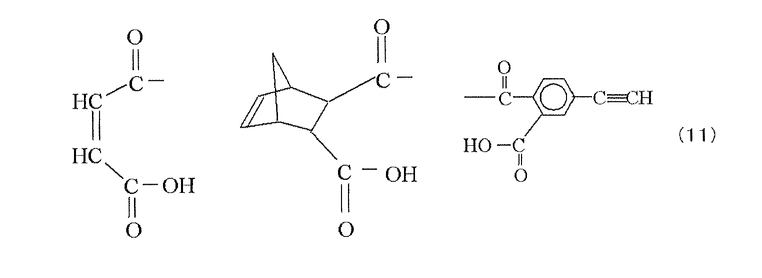

The capping method is not limited to the above method, but the acid at one end contained in the polyamide resin (A) may also be capped as an amide using an amine derivative which contains an aliphatic group or a cyclic compound group having at least one carbon-carbon double bond unit or one carbon-carbon triple bond unit.

The polyamide resin (A) comprising a repeating unit (A-1) represented by the general formula (1), a repeating unit (A-2) represented by the general formula (2) and/or a repeating unit (A-3) represented by the general formula (3) according to the present invention may have a nitrogen-containing cyclic compound at least one end of the side chain of the polyamide resin and the other end of the same. Because of this, adhesiveness of the positive photosensitive resin composition to metal wiring (especially copper wiring) or the like can be improved. This is because when one end of the polymer resin (A) has an organic group having an unsaturated group, the resin reacts, so that mechanical properties such as a tensile elongation rate of a cured film and the like are excellent. Meanwhile, when the polyamide resin (A) has a nitrogen-containing cyclic compound at least one end of the side chain and the other end, the nitrogen-containing cyclic compound reacts with metal wiring of copper and copper alloys, so that the cured film of the polyamide resin (A) shows excellent adhesiveness.

The above nitrogen-containing cyclic compound is not particularly limited, and examples thereof include a 1-(5-1H-triazoyl)methylamino group, a 3-(1H-pyrazoyl)amino group, a 4-(1H-pyrazoyl)amino group, a 5-(1H-pyrazoyl)amino group, a 1-(3-1H-pyrazoyl)methylamino group, a 1-(4-1H-pyrazoyl)methylamino group, a 1-(5-1H-pyrazoyl)methylamino group, a (1H-tetrazol-5-yl)amino group, a 1-(1H-tetrazol-5-yl)methyl-amino group, a 3-(1H-tetrazol-5-yl)benz-amino group and the like. Among these compounds, preferably used are the compounds selected from the following formula (12). Because of this, adhesiveness of a cured film of the polyamide resin (A) to metal wiring of copper and copper alloys can be further particularly improved.

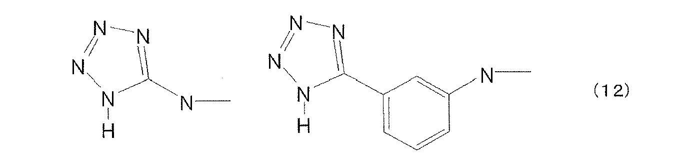

The photosensitizing agent (B) according to the present invention is not particularly limited, and examples thereof include photosensitive diazoquinone compounds. A specific example includes an ester compound of a phenolic compound with 1,2-naphthoquinone-2-diazide-5-sulfonic acid or 1,2-naphthoquinone-2-diazide-4-sulfonic acid. More specific examples include the ester compounds represented by the following formulae (13) to (16). These compounds may be used either individually or in combination of two or more kinds.

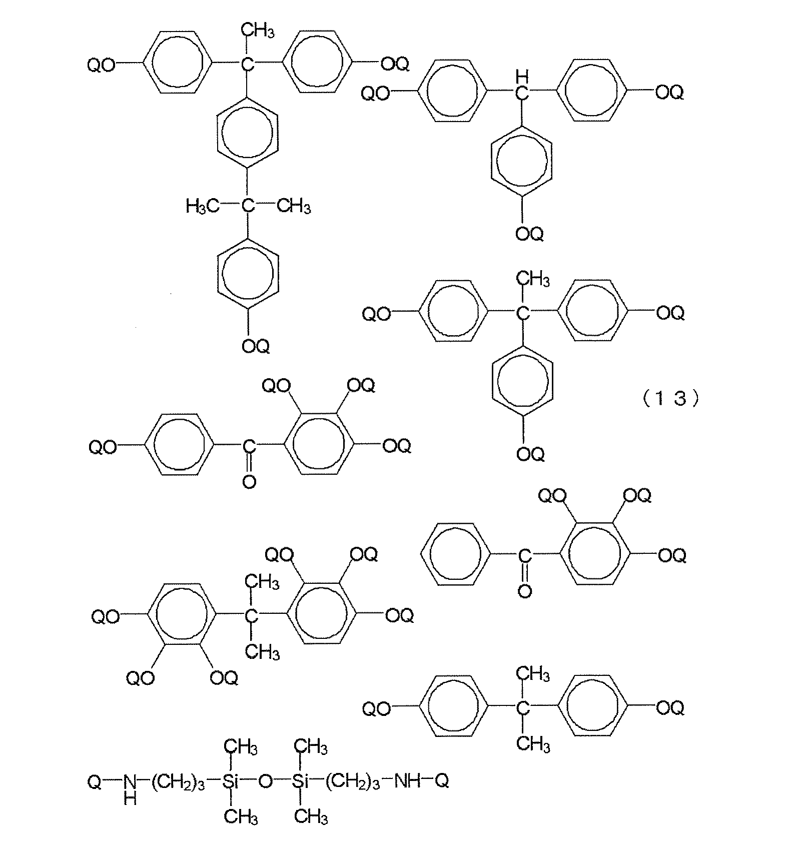

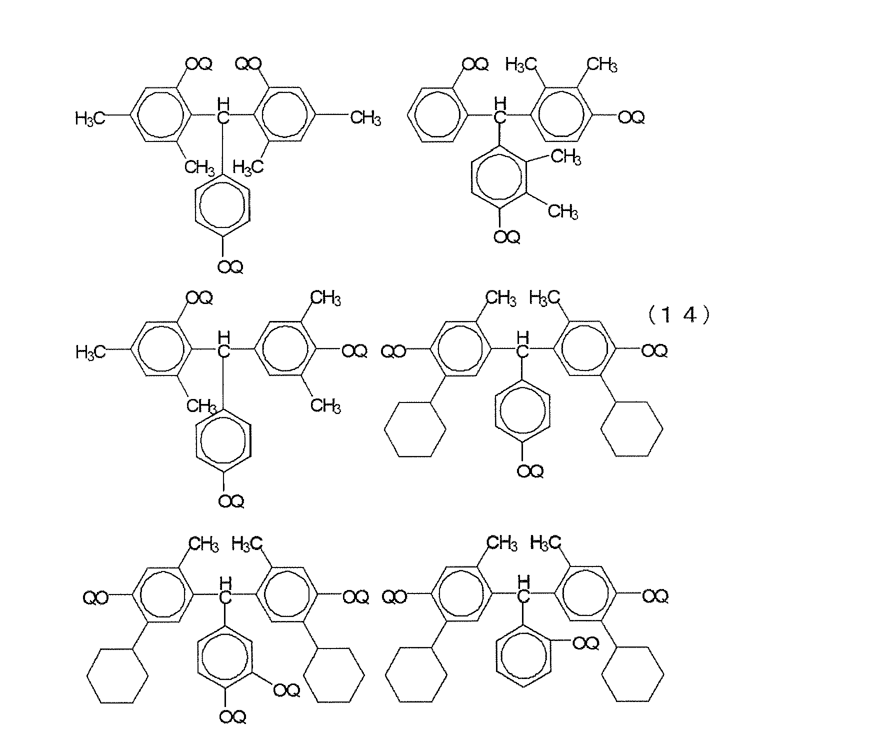

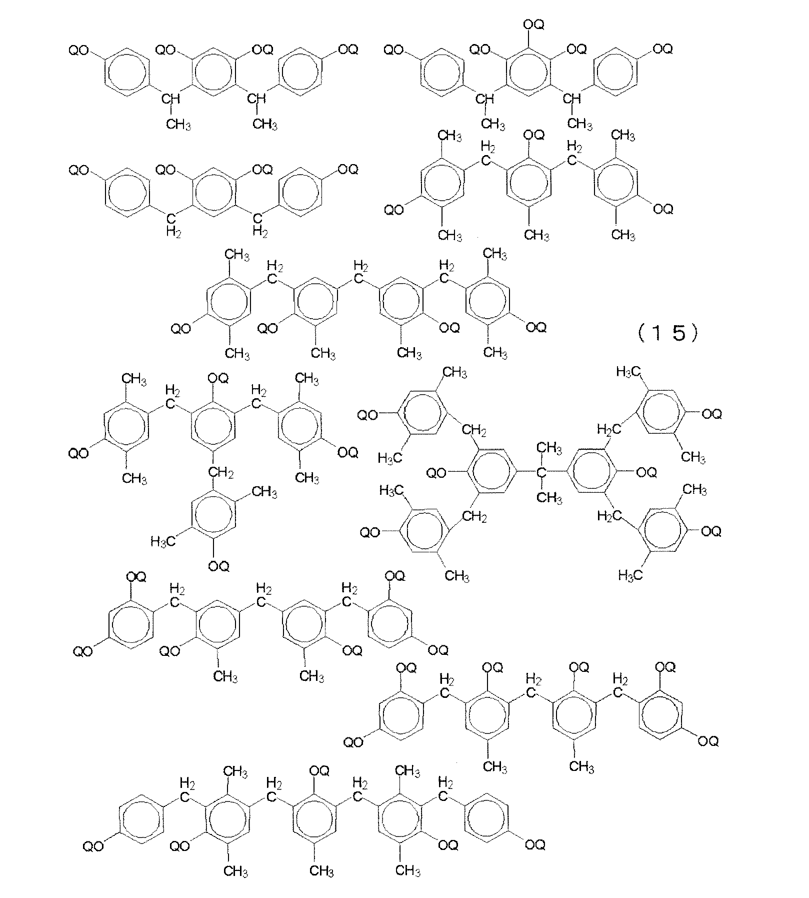

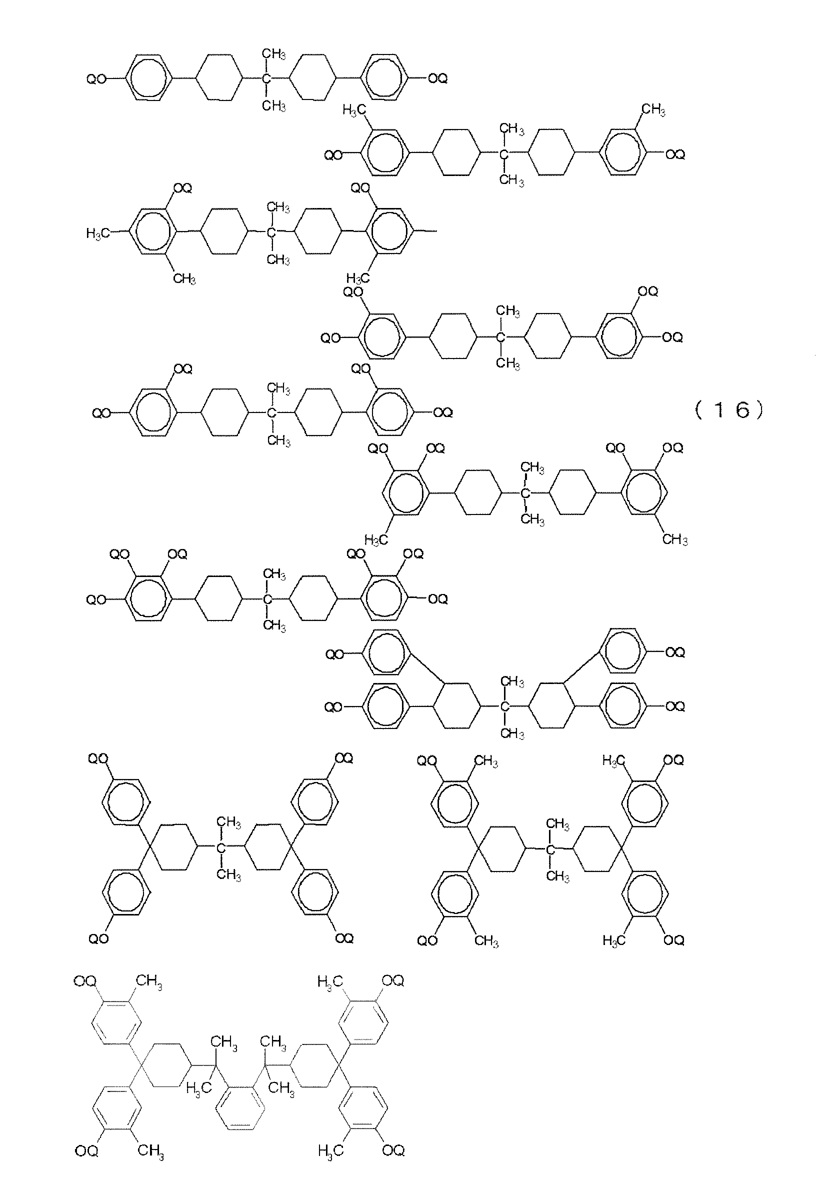

Q in the formulae (13) to (16) is a hydrogen atom or a compound selected from any of the following formula (17). Among Q of respective compounds, at least one Q is the formula (17),

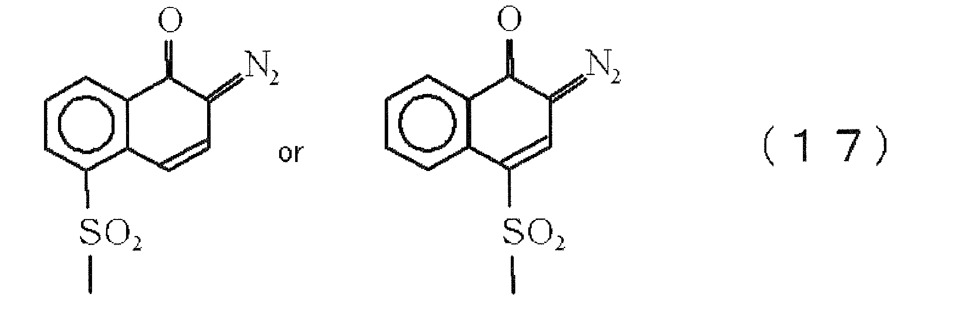

Furthermore, the positive photosensitive resin composition of the present invention may further contain a compound having a phenolic hydroxyl group for the purpose of reducing the residue (scum) during patterning by exposure and development.

The aforementioned compound having a phenolic hydroxyl group is not particularly limited, and examples thereof include the compounds represented by the formula (18). These compounds may be used either individually or in combination of two or more kinds.

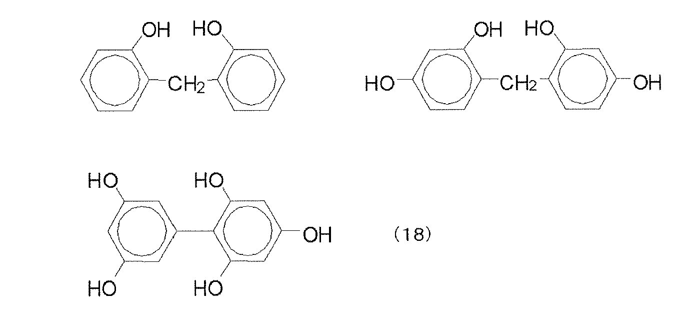

The amount of the compound having a phenolic hydroxyl group added is not particularly limited, but it is preferably from 1 to 30 parts by weight and more preferably from 1 to 20 parts by weight, based on 100 parts by weight of the repeating unit (A-1) represented by the general formula (1), the repeating unit (A-2) represented by the general formula (2) and/or the repeating unit (A-3) represented by the general formula (3). When the amount is within the above range, production of scum during development is suppressed and the solubility of the exposed area is promoted, resulting in an improvement in the sensitivity.

The positive photosensitive resin composition of the present invention may further contain additives such as an acrylic type surfactant, a silicon type surfactant, a fluorine type surfactant, a vinyl type surfactant, a silane coupling agent, an anti-oxidant or the like, as necessary.

Examples of the silane coupling agent include, though not limited to, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, N-phenyl-3-aminopropyltrimethoxysilane, 3-mercaptopropylmethyldimethoxysilane, 3-mercaptopropyltrimethoxysilane, bis(triethoxypropyl)tetrasulfide, 3-isocyanatepropyltriethoxysilane, 1,6-bis(trimethoxysilyl)hexane and silane coupling agents obtained by reacting a silicon compound having an amino group with an acid dianhydride or an acid anhydride.

The silicon compound having an amino group is not particularly limited, and examples thereof include 3-aminopropyltrimethoxysilane, N-(2-aminoethyl)-3-aminopropyltrimethoxysilane, 3-aminopropylmethyldimethoxysilane, N-(2-aminoethyl)-3-aminopropyltriethoxysilane, 3-aminopropyltriethoxysilane and the like.

The acid anhydride is not particularly limited, and examples thereof include maleic anhydride, chloromaleic anhydride, cyanomaleic anhydride, citoconic acid, phthalic anhydride and the like. Furthermore, these may be used either individually or in combination of two or more kinds.

The acid dianhydride is not particularly limited, and examples thereof include pyromellitic acid dianhydride, benzene-1,2,3,4-tetracarboxylic acid dianhydride, 3,3',4,4'-benzophenonetetracarboxylic acid dianhydride, 2,3,3',4'-benzophenonetetracarboxylic acid dianhydride, naphthalene-2,3,6,7-tetracarboxylic acid dianhydride, naphthalene-1,2,5,6-tetracarboxylic acid dianhydride, naphthalene-1,2,4,5-tetracarboxylic acid dianhydride, naphthalene-1,4,5,8-tetracarboxylic acid dianhydride, naphthalene-1,2,6,7-tetracarboxylic acid dianhydride, 4,8-dimethyl-1,2,3,5,6,7-hexahydronaphthalene-1,2,5,6-tetracarboxylic acid dianhydride, 4,8-dimethyl-1,2,3,5,6,7-hexahydronaphthalene-2,3,6,7-tetracarboxylic acid dianhydride, 2,6-dichloronaphthalene-1,4,5,8-tetracarboxylic acid dianhydride, 2,7-dichloronaphthalene-1,4,5,8-tetracarboxylic acid dianhydride, 2,3,6,7-tetrachloronaphthalene-1,4,5,8-tetracarboxylic acid dianhydride, 1,4,5,8-tetrachloronaphthalene-2,3,6,7-tetracarboxylic acid dianhydride, 3,3',4,4'-diphenyltetracarboxylic acid dianhydride, 2,2',3,3'-diphenyltetracarboxylic acid dianhydride, 2,3,3',4'-diphenyltetracarboxylic acid dianhydride, 3,3',4,4'-p-terphenyltetracarboxylic acid dianhydride, 2,2',3,3'-p-terphenyltetracarboxylic acid dianhydride, 2,3,3',4'-p-terphenyltetracarboxylic acid dianhydride, 2,2-bis(2,3-dicarboxyphenyl)-propane dianhydride, 2,2-bis(3,4-dicarboxyphenyl)-propane dianhydride, bis(2,3-dicarboxyphenyl)ether dianhydride, bis(3,4-dicarboxyphenyl)ether dianhydride, bis(2,3-dicarboxyphenyl)methane dianhydride, bis(3,4-dicarboxyphenyl)methane dianhydride, bis(2,3-dicarboxyphenyl)sulfone dianhydride, bis(3,4-dicarboxyphenyl)sulfone dianhydride, 1,1-bis(2,3-dicarboxyphenyl)ethane dianhydride, 1,1-bis(3,4-dicarboxyphenyl)ethane dianhydride, perylene-2,3,8,9-tetracarboxylic acid dianhydride, perylene-3,4,9,10-tetracarboxylic acid dianhydride, perylene-4,5,10,11-tetracarboxylic acid dianhydride, perylene-5,6,11,12-tetracarboxylic acid dianhydride, phenanthrene-1,2,7,8-tetracarboxylic acid dianhydride, phenanthrene-1,2,6,7,8-tetracarboxylic acid dianhydride, phenanthrene-1,2,9,10-tetracarboxylic acid dianhydride, pyrazine-2,3,5,6-tetracarboxylic acid dianhydride, pyrrolidine-2,3,4,5-tetracarboxylic dianhydride, thiophene-2,3,4,5-tetracarboxylic acid dianhydride, 4,4'-hexafluoroisopropylidenediphthalic acid dianhydride and the like. These acid dianhydrides may be used either individually or in combination of two or more kinds.

As the silane coupling agent obtained by reacting the silicon compound having an amino group and an acid anhydride or an acid dianhydride, preferably used are a combination of bis(3,4-dicarboxyphenyl)ether dianhydride and 3-aminopropyltriethoxysilane, a combination of 3,3',4,4'-benzophenonetetracarboxylic acid dianhydride and 3-aminopropyltriethoxysilane, a combination of bis(3,4-dicarboxyphenyl)sulfone dianhydride and 3-aminopropyltriethoxysilane, and a combination of maleic anhydride and 3-aminopropyltriethoxysilane, from the viewpoints of the compatibility of the storage stability of the positive photosensitive resin composition and adhesiveness to a substrate such as a silicon wafer or the like during development or after heating treatment.

The positive photosensitive resin composition of the present invention is used in the form of a varnish by dissolving the polyamide resin (A) comprising a repeating unit (A-1) represented by the general formula (1), a repeating unit (A-2) represented by the general formula (2) and/or a repeating unit (A-3) represented by the general formula (3), a photosensitizing agent (B) and other additives in a solvent. The solvent is not particularly limited, and examples thereof include N-methyl-2-pyrrolidone, γ-butyrolactone, N,N-dimethylacetamide, dimethyl sulfoxide, diethylene glycol dimethyl ether, diethylene glycol diethyl ether, diethylene glycol dibutyl ether, propylene glycol monomethyl ether, dipropylene glycol monomethyl ether, propylene glycol monomethyl ether acetate, methyl lactate, ethyl lactate, butyl lactate, methyl-1,3-butylene glycol acetate, 1,3-butylene glycol-3-monomethyl ether, methyl pyruvate, ethyl pyruvate, methyl-3-methoxypropionate and the like. These may be used either individually or in combination of two or more kinds.

The method of using the positive photosensitive resin composition of the present invention will be described in detail below.
The positive photosensitive resin composition of the present invention is first applied to an appropriate support (substrate) such as a silicon wafer, a ceramic substrate, an aluminum substrate or the like. When applied to a semiconductor element, the composition is used in an amount to make a film with a final thickness of 0.1 to 30 µm after curing. If the film thickness is less than the lower limit, it is difficult for the film to fully exhibit the function as the surface protection film of the semiconductor element. If it is more than the upper limit, not only it is difficult to obtain a fine processing pattern, but also it takes a long processing time, resulting in a reduction in the throughput. Examples of the method for applying the composition include spin coating using a spinner, spray coating using a spray coater, immersion, printing, roll coating and the like. Next, the coating film is dried by prebaking at 60 to 130°C and then irradiated with actinic rays to form a desired pattern. As the actinic rays, there may be used X rays, electron beams, ultraviolet rays, visible rays and the like, and those having a wavelength of 200 to 500 nm may be preferably used.

Next, the irradiated portion is dissolved and removed using a developer to obtain a relief pattern. As the developer, suitably used are an aqueous solution of alkali compounds such as inorganic alkali compounds, for example, sodium hydroxide, potassium hydroxide, sodium carbonate, sodium silicate, sodium metasilicate, ammonia water and the like; primary amines such as ethylamine, n-propylamine and the like; secondary amines such as diethylamine, di-n-propylamine and the like; tertiary amines such as triethylamine, methyldiethylamine and the like; alcohol amines such as dimethylethanolamine, triethanolamine and the like; quaternary ammonium salts such as tetramethylammonium hydroxide, tetraethylammonium hydroxide and the like; and an aqueous solution obtained by adding an appropriate amount of a water-soluble organic solvent such as an alcohol (such as methanol and ethanol) or a surfactant thereto. As the development method, there may be used spraying, paddling, immersion, application of supersonic waves, and the like.

Next, the relief pattern formed by development is rinsed. Distilled water is used as a rinse. The resulting product is then treated with heat to form an oxazole ring, an imide ring, or both of the imide ring and oxazole ring, whereby a final pattern having excellent heat resistance can be obtained.
The heat treatment is carried out preferably at 180 to 380°C and more preferably at 200 to 350°C. The heat treatment which is carried out here is the above-described heat treatment process.

Next, the cured film of the positive photosensitive resin composition according to the present invention will be described.
The cured film which is a cured product of the positive photosensitive resin composition of the present invention is useful not only for semiconductor devices such as a semiconductor element or the like, but also for display devices such as a TFT liquid crystal and organic EL, an interlayer insulating film of a multilayered circuit, a cover coat of a flexible copper-clad board, a solder resist film and a liquid crystal alignment film.

Examples of the application to semiconductor devices include a passivation film obtained by forming a cured film of the aforementioned positive photosensitive resin composition on a semiconductor element; a protecting film such as a buffer coating film obtained by forming a cured film of the aforementioned positive photosensitive resin composition on the passivation film; an insulating film such as an interlayer insulating film obtained by forming a cured film of the aforementioned positive photosensitive resin composition on the circuit formed on the semiconductor element; an α-ray shielding film; a flattening film; a projection (a resin post); a partition; and the like.

Examples of the application to display devices include a protecting film obtained by forming a cured film of the aforementioned positive photosensitive resin composition on a display element; an insulating film or a flattening film for a TFT element or a color filter; a projection for an MVA-type liquid crystal display device and the like; a partition for an organic EL element cathodes; and the like. The method of use of the composition for semiconductor devices applies to the method of use for the display devices, that is, a method of forming a patterned layer of the positive photosensitive resin composition on a substrate on which a display element or a color filter is formed may be used. High transparency is required particularly for an insulating film or a flattening film of display devices. A resin layer excellent in transparency can also be obtained by introducing a post exposure process before curing the layer of the positive photosensitive resin composition. Introduction of such a post exposure process is further preferable in practice.

The construction of respective parts of the semiconductor device of the present invention may be replaced by arbitrary constructions capable of exhibiting the same functions or arbitrary constructions may also be added thereto.

### EXAMPLES

The present invention is now illustrated in detail below with reference to Examples and Comparative Examples. However, the present invention is not restricted to these Examples.

### Example 1

### Synthesis of Polyamide Resin and Evaluation of Polyamide Resin

In a well-dried closed reaction vessel equipped with a stirrer, 60 mL of γ-butyrolactone (hereinafter referred to as GBL) and 1.21 mL (15 mmol) of pyridine were added to 1.098 g (3 mmol) of hexafluoro-2,2-bis(3-amino-4-hydroxyphenyl)propane (hereinafter referred to as AH6FP) to dissolve the mixture, and sealed with a septum cap. Next, 1.630 g (15 mmol) of trimethylsilyl chloride was added with a syringe and the mixture was stirred at room temperature for 1 hour and silylated. To this solution was added 9.380 g (7 mmol) of amine-modified dimethylsiloxane at both ends with a methyl group partially substituted with a phenyl group (a product of Shin-Etsu Chemical Co., Ltd., amine equivalent: 670 g/mol, average molecular weight: 1,340, hereinafter referred to as silicon) and the mixture was stirred to give a uniform solution, and then 2.951 g (10 mmol) of diphenyl ether-4,4'-dicarboxylic acid dichloride (hereinafter referred to as OBC) was added 3 to 4 times as powder itself. The content of the copolymer composition at this time, that is, the content of the silicon diamine component represented by [silicon]/([AH6FP]+[silicon]) × 100 (mol %), was 30 mol %. The monomer concentration was 20 % by weight when polymerization was initiated, and GBL was added in order and diluted up to 13.7% of the monomer concentration. The mixture was stirred at room temperature for 72 hours in total to obtain a uniform polyamide resin solution. This solution was properly diluted, added dropwise to a large quantity of water, precipitated, repeatedly washed with water and dried under vacuum at 100°C for 12 hours to obtain powder of a polyamide resin having a repeating unit represented by the following formulae (19) and (20).
(i) The inherent viscosity was measured by using the obtained polyamide resin. The results are shown in Table 1.

Additionally, the thus-obtained polyamide resin powder was dissolved in GBL to obtain a varnish having a concentration of 20 % by weight.
(ii) The resulting varnish was applied on a glass plate and dried in an oven at 80°C for 2 hours, and then a polyamide resin film having a film thickness of 10 µm was obtained. The i-line transmittance, g-line transmittance, and cutoff wavelength of the resulting polyamide resin film were measured. The results are shown in Table 1.
(iii) Furthermore, by use of the varnish obtained as described above, a polyamide resin film formed by casting on an electrolytic copper foil (product name: F3-WS, commercially available from Furukawa Circuit Foil Co., Ltd., thickness: 18 µm) was heated under vacuum at 300°C for 1 hour for carrying out a cyclodehydration reaction. At this time, existence of warping of a laminate of a polyamide resin film and a copper foil was observed. The results are shown in Table 1.
(iv) Furthermore, this laminate of a polyamide resin film and a copper foil was immersed in an aqueous ferric chloride solution, and the copper foil was dissolved and removed to obtain a polyamide resin film. For the resulting polyamide resin film, the glass transition temperature (Tg), 5% weight loss temperature (in nitrogen, in the air), linear expansion coefficient, elastic modulus, elongation at break and breaking strength were measured. The results are shown in Table 1.

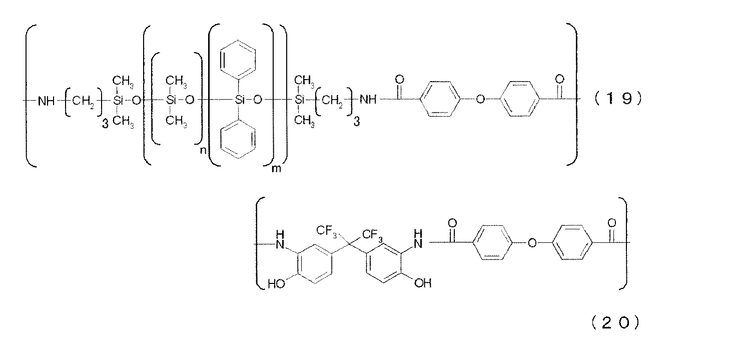

wherein, in the formula (19), each of m and n represents mol %; m is from 95 to 5 mol %; n is from 5 to 95 mol %; and m+n is 100 mol %.

### Example 2

Synthesis of a polyamide resin and evaluation of the polyamide resin were conducted in the same manner as in Example 1, except that 1.098 g (3 mmol) of AH6FP in Example 1 was changed to 1.830 g (5 mmol) and 9.380 g (7 mmol) of silicon was changed to 6.700 g (5 mmol).

### Example 3

Synthesis of a polyamide resin and evaluation of the polyamide resin were conducted in the same manner as in Example 1, except that 1.098 g (3 mmol) of AH6FP in Example 1 was changed to 2.562 g (7 mmol) and 9.380 g (7 mmol) of silicon was changed to 4.020 g (3 mmol).

### Comparative Example 1

Synthesis of a polyamide resin and evaluation of the polyamide resin were conducted in the same manner as in Example 1, except that 1.098 g (3 mmol) of AH6FP in Example 1 was changed to 2.562 g (10 mmol) and 9.380 g (7 mmol) of silicon was changed to 0 g (0 mmol).

Further, respective physical properties or the like of the polyamide resins in respective Examples and Comparative Example were measured in the following manner.

### Inherent Viscosity

The resulting polyamide resin was dissolved in GBL to prepare a 0.5 % by weight polyamide resin solution. The inherent viscosity was measured at 30°C using an Ostwald viscometer.

### Glass Transition Temperature: Tg

The glass transition temperature of the polyamide resin film (thickness: 30 µm) was determined from the peak temperature of the loss elastic modulus when measured at a temperature elevation rate of 5°C/min after cooling down to -120°C with liquid nitrogen at a frequency of 10 Hz through measurement of a dynamic viscoelasticity using a dynamic viscoelasticity measuring device (Q800 Model, commercially available from TA Instruments Company).

### Coefficient of Thermal Expansion: CTE

The coefficient of thermal expansion of the polyamide resin film (thickness: 30 µm) was determined as an average in the range of 100 to 200°C by the elongation of a test piece at a temperature elevation rate of 5°C/min with a load of 0.5 g (per film thickness of 1 um) through thermomechanical analysis using a thermomechanical analysis apparatus (TMA4000, commercially available from Bruker AXS, Inc.).

### Elastic Modulus, Elongation at Break and Breaking Strength

A test piece (3 mm × 30 mm) of the polyamide resin film (thickness: 30 µm) was subjected to a tensile test (elongation speed: 8 mm/min) using a tensile tester (Tensilon UTM-2, commercially available from Toyo Baldwin Co., Ltd.), whereby the elastic modulus at 25°C was determined from the initial slope of a stress versus strain curve, and the elongation at break (%) was determined from the elongation rate when the film was broken. Furthermore, the breaking strength was determined from the stress when the test piece was broken. Higher elongation at break means higher toughness of the film.

### Cutoff Wavelength

The visible-ultraviolet light transmittance of the polyamide resin film (thickness: 10 µm) was measured in the range of 200 to 900 nm using an ultraviolet and visible spectrophotometer (V-530, commercially available from JASCO Corporation). A wavelength (a cutoff wavelength) to have the transmittance of not more than 0.5% was taken as an index of transparency. Shorter cutoff wavelength means excellent transparency.

### Light Transmittance (Transparency)

The light transmittance of the polyamide resin film (thickness: 10 µm) in i-line (365 nm) and g-line (435 nm) was measured using an ultraviolet and visible spectrophotometer (V-530, commercially available from JASCO Corporation). Higher transmittance means excellent transparency.

### 5% Weight Loss Temperature (T_{d}⁵ (N₂)) (T_{d}⁵ (Air))

T_{d}⁵ (N₂) and T_{d}⁵ (Air) were respectively determined as the 5% weight loss temperature in nitrogen and in the atmosphere using a thermograyimetric analyzer (TG-DTA2000, commercially available from Bruker AXS, Inc.).

### Warping of Copper Foil

The polyamide resin film formed by casting it onto an electrolytic copper foil having a size of 10 cm × 10 cm (product name: F3-WS, commercially available from Furukawa Circuit Foil Co., Ltd., thickness: 18 µm) was heated under vacuum at 300°C for 1 hour for carrying out a cyclodehydration reaction. Lifting of four corners of the laminate of the polyamide resin film (thickness: 30 µm) and the copper foil was visually observed and existence of warping was observed.

**Table 1**

| | | Example 1 | Example 2 | Example 3 | Comparative Example 1 |
|---|---|---|---|---|---|
| Inherent Viscosity (η) (dL/g) | | 0.240 | 0.798 | 0.673 | 0.367 |
| Glass Transition Temperature Tg (°C) | | -22.6 | | -24.7 | 311 |
| Coefficient of Linear Thermal Expansion CTE (ppm/K) | | 3641 | | 2677 | 58 |
| 5% Weight Loss Temperature T_{d}⁵ (N₂) (°C) | | 397 | 369 | 392 | 532 |
| 5% Weight Loss Temperature T_{d}⁵ (Air) (°C) | | 364 | 34 9 | 387 | 511 |
| Tensile Elastic Modulus (GPa) | | 0.026 | 0.069 | 0.580 | 2.340 |
| Tensile Elongation at Break (%) | | 141.1 | 30.1 | 10.6 | 9.4 |
| Tensile Breaking Strength (MPa) | | 10 | 13 | 30 | 110 |
| Cutoff Wavelength (nm) | | 309 | 330 | 325 | 340 |
| Light Transmittance T (%) | 365 nm | 79.4 | 78.1 | 71.6 | 58.1 |
| | 435 nm | 89.9 | 91.9 | 84.9 | 89.1 |
| Warping of Copper Foil | | No | No | No | Yes |

As shown in Table 1, the polyamide resin film in Example 1 exhibited a low elastic modulus (0.026 GPa) which was suitable for prevention of warping of a semiconductor element. Also, all respective polyamide resin films in respective Examples have resulted in respective excellent measurement values.

In particular, as clear from the tensile elastic modulus, respective polyamide resin films in respective Examples clearly exhibited excellent low stress properties. This was guessed because a siloxane skeleton was introduced into the polyamide resin skeleton.

The present application claims priority to Japanese Patent Application No. 2009-031743 filed on February 13, 2009. The contents of the application are incorporated herein by reference in their entirety.

## Claims

1. A positive photosensitive resin composition comprising a polyamide resin (A) and a photosensitizing agent (B), wherein the polyamide resin comprises a repeating unit (A-1) represented by the following general formula (1), a repeating unit (A-2) represented by the following general formula (2) and/or a repeating unit (A-3) represented by the following general formula (3), 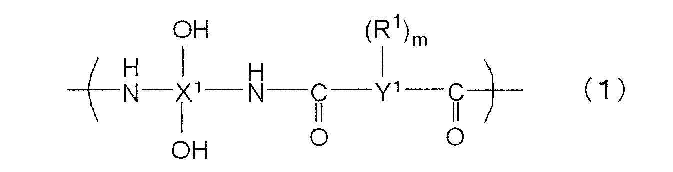 wherein, in the formula, each of X¹ and Y¹ is an organic group; R¹ is any one of a hydrogen atom, a hydroxyl group and -O-R²; m is an integer of 0 to 8; when there are a plurality of R¹, R¹ may be the same or different from each other; and R² is an organic group having 1 to 15 carbon atoms, 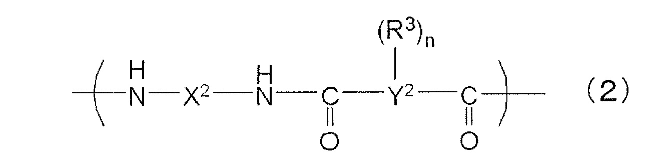 wherein, in the formula, X² is a structural unit represented by the following general formula (40); Y² is an organic group; R³ is any one of a hydrogen atom, a hydroxyl group and -O-R⁴; n is an integer of 0 to 8; when there are a plurality of R³, R³ may be the same or different from each other; and R⁴ is an organic group having 1 to 15 carbon atoms, 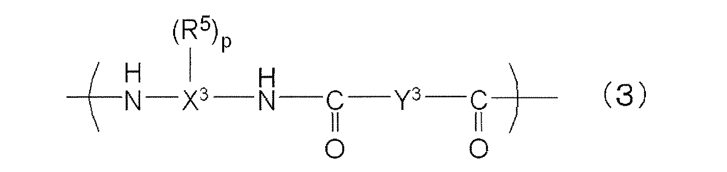 wherein, in the formula, X³ is an organic group; Y³ is a structural unit represented by the following general formula (40) ; R⁵ is any one of a hydrogen atom, a hydroxyl group and -O-R⁶; p is an integer of 0 to 8; when there are a plurality of R⁵, R⁵ may be the same or different from each other; and R⁶ is an organic group having 1 to 15 carbon atoms, 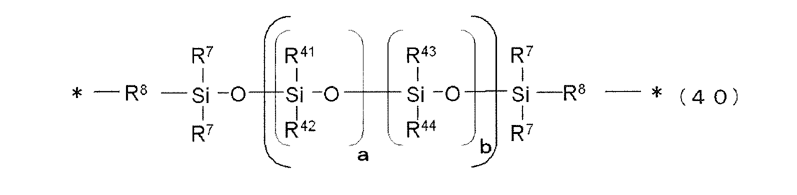 wherein, in the formula, R⁷ is a hydrogen atom or a hydrocarbon group having 1 to 10 carbon atoms; R⁸ is a hydrocarbon group having 1 to 10 carbon atoms; at least one of R⁴¹, R⁴², R⁴³ and R⁴⁴ is an aryl group, and other groups of the R⁴¹, R⁴², R⁴³ and R⁴⁴ are each a hydrogen atom or an organic group having 1 to 30 carbon atoms, which may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2) and/or a C=O group represented by the general formula (3).

2. The positive photosensitive resin composition according to claim 1, wherein the structural unit represented by the aforementioned general formula (40) is represented by the following general formula (4), 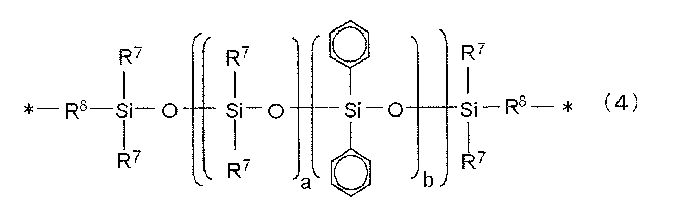 wherein, in the formula, R⁷ is a hydrogen atom or a hydrocarbon group having 1 to 10 carbon atoms; R⁸ is a hydrocarbon group having 1 to 10 carbon atoms; R⁷ and R⁸ may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2) and/or a C=O group represented by the general formula (3).

3. The positive photosensitive resin composition according to claim 1 or 2, wherein the molecular weight of the structural unit represented by the general formula (40) is from 400 to 4,000.

4. The positive photosensitive resin composition according to claim 2 or 3, wherein the polyamide resin comprises a repeating unit (A-2) represented by the general formula (2), 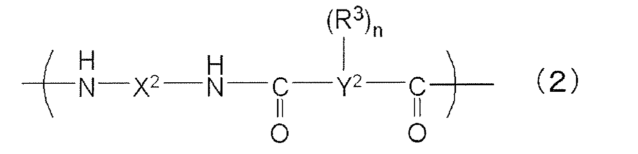 wherein, in the formula, X² is a structural unit represented by the following general formula (4); Y² is an organic group; R³ is any one of a hydrogen atom, a hydroxyl group and -O-R⁴; n is an integer of 0 to 8; when there are a plurality of R³, R³ may be the same or different from each other; and R⁴ is an organic group having 1 to 15 carbon atoms, 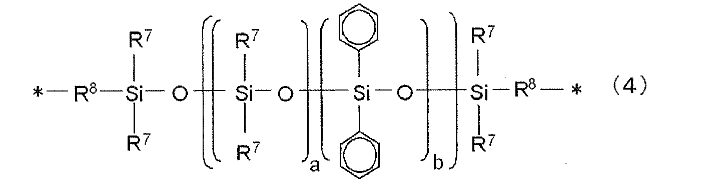 wherein, in the formula, R⁷ is a hydrogen atom or a hydrocarbon group having 1 to 10 carbon atoms; R⁸ is a hydrocarbon group having 1 to 10 carbon atoms; R⁷ and R⁸ may respectively be the same or different from each other; each of a and b represents mol %; a is from 5 to 95 mol %; b is from 95 to 5 mol %; a+b is 100 mol %; and the asterisk (*) represents bonding to an NH group represented by the general formula (2).

5. The positive photosensitive resin composition according to any one of claims 1 to 4, wherein the molar ratio ((A-1)/{(A-2)+(A-3)}) of the repeating unit (A-1) represented by the general formula (1) to the repeating unit (A-2) represented by the general formula (2) and/or the repeating unit (A-3) represented by the general formula (3) is from 0.05 to 0.95.

6. The positive photosensitive resin composition according to any one of claims 1 to 4, wherein X¹ in the structural unit represented by the general formula (1) contains at least one kind selected from the groups of the following formula (5), 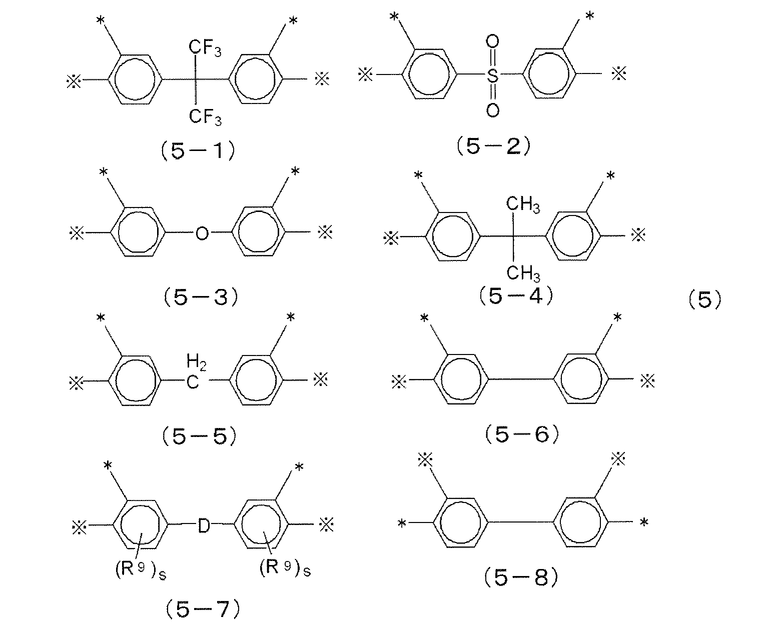 wherein, the asterisk (*) represents bonding to an NH group; 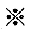 represents bonding to a hydroxyl group; D in the formula is -CH₂-, -CH(CH₃)-, -C(CH₃)₃-, -O-, -S-, -SO₂--CO-, -NHCO-, -C(CF₃)₂- or a single bond; s is an integer of 1 to 3; R⁹ represents one selected from an alkyl group, an alkoxy group, an acyloxy group and a cycloalkyl group; and when there are a plurality of R⁹, R⁹ may be the same or different from each other.

7. The positive photosensitive resin composition according to any one of claims 1 to 4, wherein Y¹ in the structural unit represented by the general formula (1) contains at least one kind selected from the groups of the following formula (6), 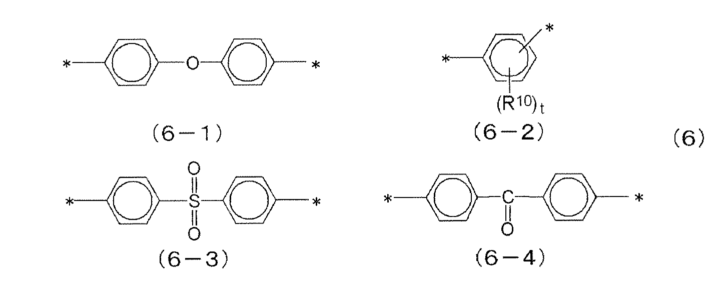 wherein, the asterisk (*) represents bonding to a C=O group; t is an integer of 0 to 2; R¹⁰ represents one selected from an alkyl group, an alkyl ester group, an alkyl ether group and a halogen atom; and when there are a plurality of R¹⁰, R¹⁰ may be the same or different from each other.

8. A cured film comprising a cured product of the positive photosensitive resin composition according to any one of claims 1 to 7, wherein the elastic modulus at 25°C is not more than 1.5 GPa.

9. A protecting film comprising the cured film according to claim 8.

10. An insulating film comprising the cured film according to claim 8.

11. A semiconductor device comprising the cured film according to claim 8.

12. A display device comprising the cured film according to claim 8.
